# EUROPEAN PATENT APPLICATION

(11) **EP 4 270 463 A2**
(43) Date of publication of application: **01.11.2023**
(21) Application number: 23169527.1
(22) Date of filing: 24.04.2023
(51) Int. Cl.: H01L 21/822, H01L 27/06, H01L 21/8238, H01L 27/092

(54) **NANOSHEET INTERVAL CONTROL STRUCTURE IN 3D NANOSHEET STACKED DEVICES**

(30) Priority: 27.04.2022 US 202263335417 P; 10.06.2022 US 202263351168 P; 13.10.2022 US 202217965551
(71) Applicant: Samsung Electronics Co., Ltd., Suwon-si, Gyeonggi-do 16677 (KR)
(72) Inventor: JO, Gunho, San Jose, CA, 95134 (US); HONG, Byounghak, San Jose, CA, 95134 (US); BAEK, Jaejik, San Jose, CA, 95134 (US); YUN, Seungchan, San Jose, CA, 95134 (US)
(74) Representative: Kuhnen & Wacker Patent- und Rechtsanwaltsbüro PartG mbB

(57) **Abstract**

Provided is a multi-stack semiconductor device (10) that includes: a lower nanosheet transistor (10L) including a plurality of lower channel layers (110C) surrounded by a gate structure (115); and an upper nanosheet transistor (10U) stacked on the lower nanosheet transistor (10L) and including a plurality of upper channel layers (120C) surrounded by the gate structure (115), wherein the lower channel layers (110C) have a smaller channel interval than the upper channel layers (120C).

## Description

### BACKGROUND

### 1. Field

Apparatuses and methods according to embodiments relate to a three-dimensionally-stacked (3D-stacked) or multi-stack semiconductor device in which a lower nanosheet transistor and an upper nanosheet transistor have a different channel layer interval.

### 2. Description of the Related Art

Growing demand for integrated circuits having high device density has introduced a three-dimensional (3D) multi-stack semiconductor device in which two or more field-effect transistors such as nanosheet transistors are vertically stacked. The nanosheet transistor is characterized by one or more nanosheet channel layers vertically stacked on a substrate and a gate structure surrounding the nanosheet channel layers. Thus, the nanosheet transistor is referred to as gate-all-around (GAA) transistor, multi-bridge channel field-effect transistor (MBCFET).

In a multi-stack semiconductor device including two vertically stacked nanosheet transistors, one or more nanosheet channel layers of each nanosheet transistor function as a channel structure of the nanosheet transistor, and these channel layers are surrounded by a gate structure. The gate structure may include a gate dielectric layer, a work-function metal layer and a gate electrode pattern for each of a lower nanosheet transistor at a lower stack and an upper nanosheet transistor at an upper stack in the multi-stack semiconductor device.

When there is a requirement to differentiate the gate structure between the lower nanosheet transistor and the upper nanosheet transistor, the work-function metal layer may be differently formed for the two nanosheet transistors. For example, when the multi-stack semiconductor device is to form a complementary-metal-oxide transistor (CMOS) device including opposite polarity field-effect transistors (FETs), that is, a p-type lower nanosheet transistor and an n-type lower nanosheet transistor, a work-function metal layer of a gate structure of the lower nanosheet transistor (i.e., a lower work-function metal layer of a lower gate structure) and a work-function metal layer of a gate structure of the upper nanosheet transistor (i.e., an upper work-function metal layer of an upper gate structure) may be formed to include different materials and/or have different dimensions. Thus, the lower gate structure and the upper gate structure may be able to have different threshold voltages to drive the lower nanosheet transistor and the upper nanosheet transistor.

The gate structure having the lower work-function metal layer and the upper work-function metal layer different from each other may be obtained by forming a gate dielectric layer surrounding each of nanosheet channel layers for the lower nanosheet transistor and the upper nanosheet transistor, forming a work-function metal layer surrounding the gate dielectric layer, removing the work-function metal layer formed on the nanosheet channel layers at an upper stack leaving the work-function metal layer only on the nanosheet channel layers at a lower stack (i.e., the lower work-function metal layer), forming another work-function metal layer (i.e., the upper work-function metal layer) to surround the nanosheet channel layers at the upper stack, and forming a gate electrode pattern to surround the two work-function metal layers.

However, the above process of forming the different work-function metal layers exposes various challenges. For example, during the removal operation of the work-function metal layer formed on the upper-stack nanosheet channel layers through wet etching, the work-function metal layer formed on the lower-stack nanosheet channel layers (i.e., the lower work-function metal layer) may also be etched or damaged by the wet etching. This risk may increase when the lower-stack nanosheet channel layers and the upper-stack nanosheet channel layers have different channel widths. Further, due to the high aspect ratio of the multi-stack nanosheet transistor structure and nano-scale intervals between vertically stacked nanosheet channel layers, formation of the work-function metal layer and the gate electrode pattern thereon becomes complicated and difficult. Thus, a process of protecting the lower work-function metal layer is necessary, which often requires additional complicated patterning and/or deposition steps.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a multi-stack semiconductor device in which a channel interval is different at a lower nanosheet transistor and an upper nanosheet transistor, and a method of manufacturing the same, according to embodiments.

According to an embodiment, there is provided a multi-stack semiconductor device which may include: a lower nanosheet transistor including a plurality of lower channel layers surrounded by a gate structure; and an upper nanosheet transistor stacked on the lower nanosheet transistor and including a plurality of upper channel layers surrounded by the gate structure, wherein the lower channel layers have a smaller channel interval than the upper channel layers.

According to an embodiment, there is provided a multi-stack semiconductor device which may include: a lower nanosheet transistor including a plurality of lower channel layers surrounded by a gate structure; and an upper nanosheet transistor stacked on the lower nanosheet transistor and including a plurality of upper channel layers surrounded by the gate structure, wherein the gate structure includes a lower work-function metal layer formed on the lower channel layers, an upper work-function metal layer formed on the upper channel layers, and a gate electrode pattern formed on the upper work-function metal layer, and wherein the gate electrode pattern is formed between the upper channel layers and is not formed between the lower channel layers.

According to an embodiment, there is provided a multi-stack semiconductor device which may include: a lower nanosheet transistor including a plurality channel layers surrounded by a gate structure; and an upper nanosheet transistor stacked on the lower nanosheet transistor and including a plurality of upper channel layers surrounded by the gate structure, wherein the gate structure includes a lower work-function metal layer formed on the lower channel layers, and an upper work-function metal layer formed on the upper channel layers, the upper work-function metal layer and the lower work-function metal layer are formed of different materials, respectively, and the upper work-function metal layer is formed on side surfaces of lower channel layers and side surfaces of the lower work-function metal layer formed between the lower channel layers.

According to an embodiment, there is provided a multi-stack semiconductor device which may include: a lower field-effect transistor including one or more lower channel layers surrounded by a gate structure; and an upper field-effect transistor stacked on the lower field-effect transistor and including one or more upper channel layers surrounded by the gate structure, wherein the gate structure includes a lower work-function metal layer formed on the lower channel layers, an upper work-function metal layer formed on the upper channel layers, and a gate electrode pattern formed on the upper work-function metal layer, and wherein the gate electrode pattern is formed between the upper channel layers and is not formed between the lower channel layers.

According to embodiments, there is provided a method of manufacturing a multi-stack semiconductor device. The method may include: providing a multi-stack structure including a plurality of lower channel layers and a plurality of upper channel layers stacked on the lower channel layers, the upper channel layers having a smaller channel width than the lower channel layers; forming an initial work-function metal layer to surround the lower channel layers and the upper channel layers; removing the initial work-function metal layer except portions thereof between the lower channel layers so that the portions thereof form a lower work-function metal layer; replacing the removed initial work-function metal layer with an upper work-function metal layer having a material not included in the initial work-function metal layer; and forming a gate electrode pattern on the upper work-function metal layer.

### BRIEF DESCRIPTION OF DRAWINGS

Example embodiments of the inventive concept will be more clearly understood from the following detailed description taken in conjunction with the accompanying drawings in which:
FIGS. 1A-1E illustrate a multi-stack semiconductor device in which a lower nanosheet transistor and an upper nanosheet transistor have a different channel layer interval, according to an embodiment;
FIGS. 2 to 7 illustrate semiconductor device structures after respective steps of a method of manufacturing the multi-stack semiconductor device shown in FIGS. 1A-1E, according to an embodiment;
FIG. 8 illustrates a flowchart for a method of manufacturing a multi-stack semiconductor device in which a lower nanosheet transistor and an upper nanosheet transistor have a different channel layer interval, according to an embodiment; and
FIG. 9 is a schematic block diagram illustrating an electronic device including a multi-stack semiconductor device in which a channel layer interval is different at a lower nanosheet transistor and an upper nanosheet transistor, according to an embodiment, according to an example embodiment.

### DETAILED DESCRIPTION OF EXAMPLE EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, sacrificial isolation layers and channel isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be understood that, although the terms 1^{st}, 2^{nd}, 3^{rd}, 4^{th}, etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor may or may not be described in detail herein. For example, a certain isolation layer or structure of a semiconductor device may be omitted herein when this layer or structure is not related to the various of aspects of the embodiments.

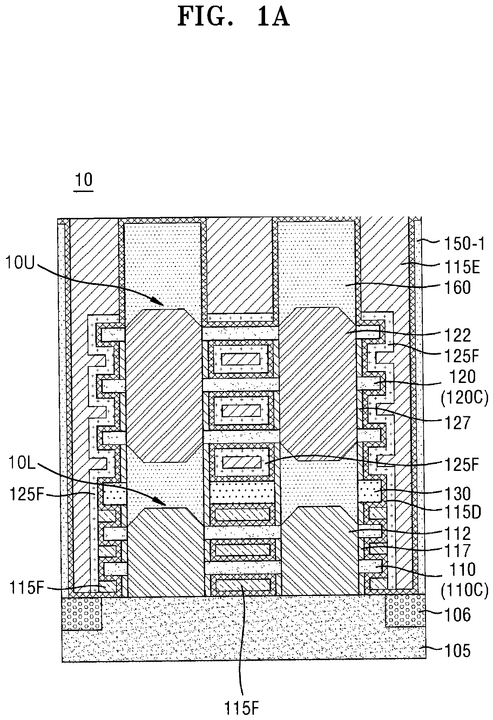

FIGS. 1A-1E illustrate a multi-stack semiconductor device in which a lower nanosheet transistor and an upper nanosheet transistor have a different channel layer interval, according to an embodiment.

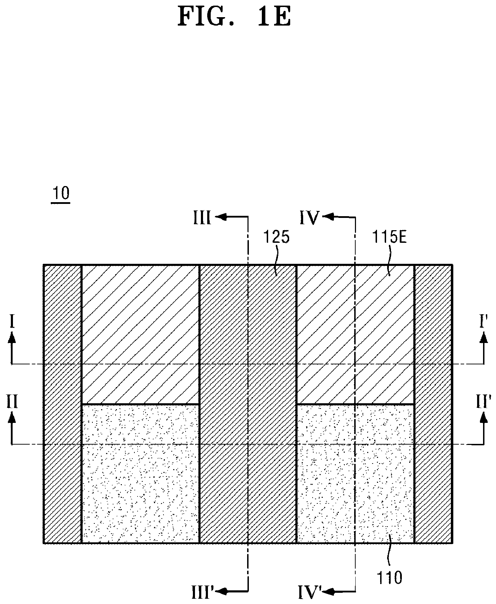

FIG. 1E is a top plan view of a multi-stack semiconductor device 10 which shows a channel structure and a gate structure enclosing the channel structure without showing a plurality of other structures or elements illustrated in FIGS. 1A-1D, for brevity purposes. FIGS. 1A-1D are cross-sectional views of the multi-stack semiconductor device 10 taken along lines I-I', II-II', III-III' and IV-IV' indicated in FIG. 1E, respectively.

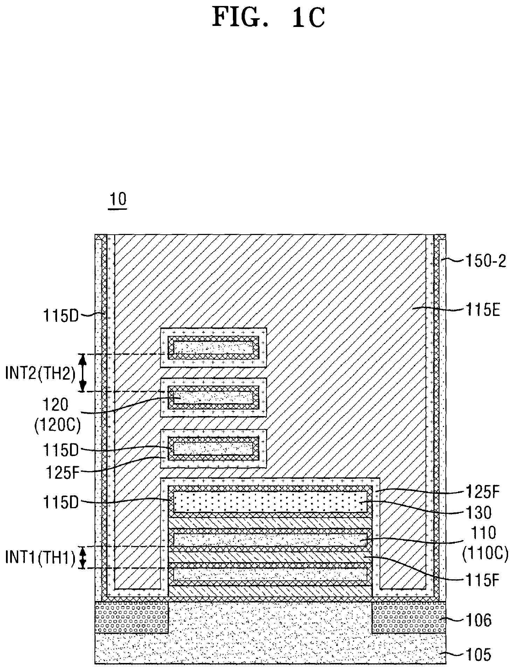

It is understood herein that the lines I-I' and II-II' shown in FIG. 1E indicate a channel-length direction of the multi-stack semiconductor device 10, and the lines III-IIF, IV-IV' shown in FIG. 1E indicate a channel-width direction of the multi-stack semiconductor device 10. Thus, FIGS. 1A-1B show lengths of channel structures and source/drain regions connected by the channel structures, and FIGS. 1C-1D show widths of the channel structures and the source/drain regions, in the multi-stack semiconductor device 10.

Referring to FIGS. 1A-1C, the multi-stack semiconductor device 10 may include a lower nanosheet transistor 10L and an upper nanosheet transistor 10U formed on a substrate 105. The substrate 105 may be a silicon (Si) substrate although it may include other materials such as silicon germanium (SiGe), silicon carbide (SiC), not being limited thereto. A shallow trench isolation (STI) structure 106 including silicon nitride or silicon oxide may be formed on or around the substrate 105 to isolate the multi-stack semiconductor device 10 from another multi-stack semiconductor device or circuit element in an integrated circuit including the multi-stack semiconductor device 10.

The lower nanosheet transistor 10L may include a plurality of lower channel layers 110C as a lower channel structure 110 of the multi-stack semiconductor device 10. The lower channel layers 110C may be nanosheet layers which are vertically stacked and horizontally extended to be parallel with each other above the substrate 105. The upper nanosheet transistor 10U may also include a plurality of upper channel layers 120C as an upper channel structure 120 of the multi-stack semiconductor device 10. Like the lower channel layers 110C, the upper channel layers 120C may also be nanosheet layers which are vertically stacked and horizontally extended to be parallel with each other above the lower channel layers 110C. The channel layers 110C and 120C may include a semiconductor material(s) such as silicon that may have been epitaxially grown from the substrate 105.

According to an embodiment, an isolation layer 130 may be formed above an uppermost of the lower channel layers 110C to isolate the lower channel structure 110 from the upper channel structure 120. One or more materials forming the isolation layer 130 may include, for example, silicon nitride, not being limited thereto.

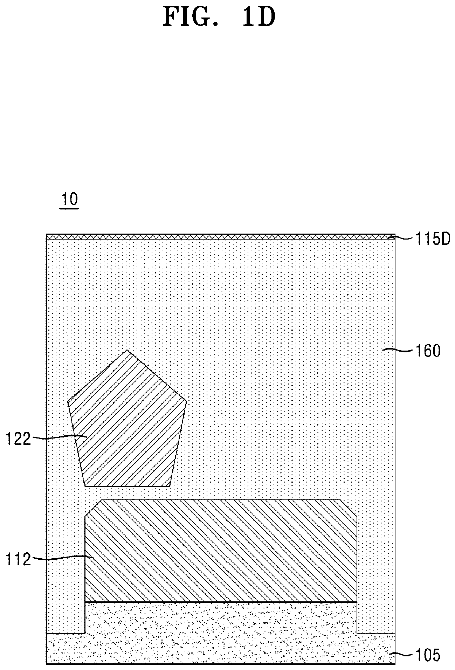

According to an embodiment, each of the lower channel layers 110C and the upper channel layers 120C may have an equal thickness in a range of about 4-6 nm, and an equal length in a range of about 18-24 nm not being limited thereto. However, each of the upper channel layers 120C may have a smaller width than each of the lower channel layers 110C, according to an embodiment, as shown in FIG. 1C. For example, the upper channel layers 120C may each have a width of about 23-27 nm and the lower channel layers 110C may each have a width of about 43-47 nm. Due to this channel-width difference between the lower channel structure 110 and the upper channel structure 120, lower source/drain regions formed on the lower channel structure 110 may also have a different width from upper source/drain regions formed on the upper channel structure 120, as shown in FIG. 1D, according to an embodiment. This channel-width difference will be further described later.

In contrast, the upper channel structure 120 may have a greater number of channel layers than the lower channel structure 110, according to an embodiment. For example, the number of the upper channel layers 120C may be three (3) while the number of the lower channel layers 110C may be two (2), although these numbers are not limited thereto. Thus, while the channel width is different between the lower channel structure 110 and the upper channel structure 120, these two channel structures 110 and 120 may be formed of different numbers of channel layers so that the multi-stack semiconductor device 10 may have an equal or similar effective channel width (W_{eff}) in the lower nanosheet transistor 10L and the upper nanosheet transistor 10U. However, according to embodiments, the two nanosheet transistors 10L and 10U may not have an equal or similar effective channel width.

In addition, a channel interval of the lower channel layers 110C is smaller than that of the upper channel layers 120C, according to an embodiment. In other words, a vertical distance between two neighboring lower channel layers 110C is smaller than that between two neighboring upper channel layers 120C. For example, the lower channel layers 110C may have a lower channel interval INT1 which may be about 4-6 nm, while the upper channel layers 120C may have an upper channel interval INT2 which may be about 7-9 nm, not being limited these specific numbers. This channel interval difference of the lower channel layers 110C and the upper channel layers 120C is provided to address difficulty in forming a lower work-function metal layer and an upper work-function metal layer in a multi-stack semiconductor device that was described earlier in the Background section. Due to this channel interval difference, a gate structure 115 of the multi-stack semiconductor device 10 have a smaller thickness at a space between the lower channel layers 110C than at a space between the upper channel layers 120C, as will be described later.

Referring to FIGS. 1A-1C, lower source/drain regions 112 may be formed on both ends of the lower channel structure 110 including the lower channel layers 110C in the channel-length direction. The lower source/drain regions 112 may also be epitaxial structures grown from the lower channel layers 110C and/or the substrate 105, and thus, may include the same or similar material(s) of the lower channel layers 110C and the substrate 105. Each of the lower channel layers 110C, at both ends thereof, may be connected to the lower source/drain regions 112. Similarly, upper source/drain regions 122 may be formed on both ends of the upper channel structure including the upper channel layers 120C in the channel-length direction. The upper source/drain regions 122 may be epitaxial structures grown from the upper channel layers 120C, and thus, may include the same or similar material(s) of the upper channel layers 120C. Each of the upper channel layers 120C, at both ends thereof, may be connected to the upper source/drain regions 122.

The lower source/drain regions 112 and the upper source/drain regions 122 may be doped with p-type or n-type dopants, depending on the type of field-effect transistor (FET) to be formed by the lower source/drain regions 112 and upper source/drain regions 122, respectively. For example, the lower source/drain regions 112 may be doped with or implanted by p-type dopants such as boron (B), gallium (Ga), etc. to form the lower nanosheet transistor 10L as a p-type FET (PFET), and the upper source/drain regions 122 may be doped with or implanted by n-type dopants such as phosphorous (P), arsenic (As), indium (In), etc. to form the upper nanosheet transistor 10U as an n-type FET (NFET). However, the embodiments are not limited thereto. The lower source/drain regions 112 may include the n-type dopants while the upper source/drain regions 122 include the p-type dopants. Further, the lower source/drain regions 112 and the upper source/drain regions 122 may all include the n-type dopants or the p-type dopants.

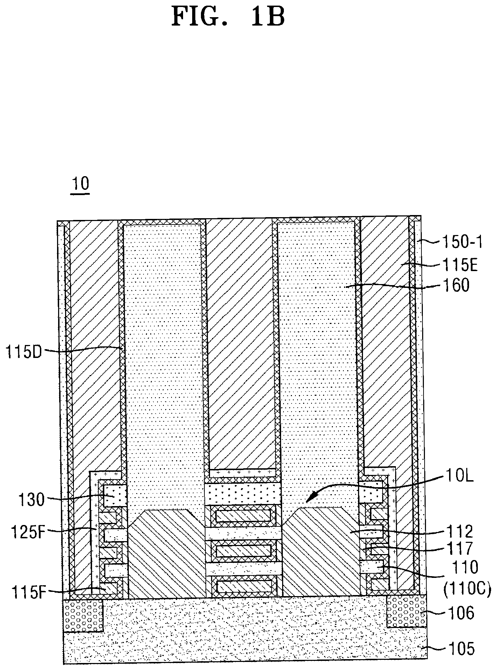

As shown in FIG. 1A, an interlayer dielectric (ILD) structure 160 may be formed above the upper source/drain regions 122 and between the upper source/drain regions 122 and the lower source/drain regions 112 at a region where the lower channel structure 110 and the lower source/drain regions 112 are vertically overlapped by the upper channel structure 120 and the upper source/drain regions 122, respectively (hereafter "overlapping region"). As shown in FIG. 1A, the overlapping region includes the cross-section of the multi-stack semiconductor device (FIG. 1A) along the lines I-I' shown in FIG. 1E. The ILD structure 160 may also be formed above the lower source/drain regions 112 at a region where the lower channel structure 110 and the lower source/drain regions 112 are not vertically overlapped by the upper channel structure 120 and the upper source/drain regions 122, respectively (hereafter "non-overlapping region"). The non-overlapping region includes the cross-section of the multi-stack semiconductor device (FIG. 1B) along the lines II-II' shown in FIG. 1E. The multi-stack semiconductor device 10 may have the overlapping region and the non-overlapping region due to the difference of the channel width between the lower channel structure 110 and the upper channel structure 120 as described above. The ILD structure 160 may isolate the lower source/drain regions 112 from the upper source/drain regions 122, and may also isolate the lower source/drain regions 112 and the upper source/drain regions 122 from other circuit elements in the multi-stack semiconductor device 10.

FIGS. 1A-1C also show that a 1^{st} isolation structure 150-1 and a 2^{nd} isolation structure 150-2 may be formed at sides of the multi-stack semiconductor device 10. According to an embodiment, the 1^{st} isolation structure 150-1 may be a diffusion break structure that isolates the lower source/drain regions 112 and the upper source/drain regions 122 from other source/drain regions in an integrated circuit including the multi-stack semiconductor device 10. According to an embodiment, the 2^{nd} isolation structure 150-2 may be a gate-cut isolation structure that isolates the gate structure 115 of the multi-stack semiconductor device 10 from gate structures of other multi-stack semiconductor devices in the channel width-direction. The 1^{st} isolation structure 150-1 and the 2^{nd} isolation structure 150-2 may each include silicon oxide or silicon nitride, not being limited thereto.

FIG. 1D shows that the upper source/drain region 122 may have a smaller width than the lower source/drain region 112 in the channel-width direction. This is because the upper source/drain region 122 is grown from the upper channel structure 120 including the upper channel layers 120C having a smaller width than the lower channel structure 110 including the lower channel layers 110C, as described above and shown in FIG. 1C. Due to this channel-width difference, a portion of the lower channel structure 110 may not be vertically overlapped by the upper channel structure 120 as shown in FIG. 1C, and thus, this non-overlapping region is distinguished from the overlapping region in the multi-stack semiconductor device 10.

The multi-stack semiconductor device 10 may have the above-described channel-width difference to enable a lower source/drain region contact structure (not shown), which is extended down from a front-end-of-line (FEOL) structure (not shown) above the multi-stack semiconductor device, to land on a top surface of the lower source/drain region 112 shown in FIG. 1D. Otherwise, if the lower channel structure 110 and the upper channel structure 120 have an equal channel width, the lower source/drain regions 112 and the upper source/drain regions 122 may have an equal width, and then, the lower source/drain region contact structure may have to be bent and connected to a side surface of the lower source/drain region 112, the formation of which is difficult and error prone.

While the lower source/drain regions 112 are connected to the lower channel structure 110, they may be isolated from the gate structure 115 by a lower inner spacer 117, as shown in FIG. 1A. Similarly, the upper source/drain regions 122 connected to the upper channel structure 120 may be isolated from the gate structure 115 by an upper inner spacer 127, as also shown in FIG. 1A. The inner spacers 117 and 127 may be formed of one or more materials including silicon nitride, silicon oxide, silicon oxynitride, silicon oxycarbide, silicon boron carbonitride, silicon oxy carbonitride, etc. not being limited thereto.

Referring to FIGS. 1A-1C, the gate structure 115 may include a gate dielectric layer 115D, a lower work-function metal layer 115F, an upper work-function metal layer 125F, and a gate electrode pattern 115E.

The gate dielectric layer 115D may surround the lower channel layers 110C, the upper channel layers 120C and the isolation layer 130.

The gate dielectric layer 115D may also be formed on a top surface of the substrate 105, and may be extended on the STI structure 106 out to the 1^{st} isolation structure 150-1 in the channel-length direction and the 2^{nd} isolation structure 150-2 in the channel-width direction. Further, the gate dielectric layer 115D may be extended upward along sidewalls of the 1^{st} isolation structure 150-1 and the 2^{nd} isolation structure 150-2 to top surfaces of these isolation structures 150-1 and 150-2. In addition, the gate dielectric layer 115D surrounding the lower channel layers 110C and the upper channel layers 120C may be extended along sidewalls of the ILD structure 160 to be formed on a top surface of the ILD structure 160.

The gate dielectric layer 115D may include an interfacial layer formed of silicon oxide and/or silicon oxynitride, not being limited thereto, and a high-k layer formed of hafnium oxide, hafnium silicate, hafnium oxynitride, hafnium silicon oxynitride, hafnium aluminum oxide, lanthanum oxide, lanthanum aluminum oxide, zirconium oxide, zirconium silicate, zirconium oxynitride, zirconium silicon oxynitride, titanium oxide, barium strontium titanium oxide, barium titanium oxide, strontium titanium oxide, yttrium oxide, aluminum oxide, tantalum oxide and/or lead scandium tantalum oxide, not being limited thereto. The interfacial layer may be provided to protect the channel layers 110C and 120C, facilitate growth of the high-k layer thereon, and provide the high-k layer with a necessary characteristic interface with the channel layers 110C and 120C. The high-k layer may be provided to allow an increased gate capacitance without associated current leakage at the channel layers 110C and 120C.

On the gate dielectric layer 115D, the lower work-function metal layer 115F and the upper work-function metal layer 125F are formed to define polarity types of the lower nanosheet transistor 10L and the upper nanosheet transistor 10U between p-type and n-type and/or control respective gate threshold voltages for the two nanosheet transistors 10L and 10U.

According to an embodiment, the lower work-function metal layer 115F may be formed between the substrate 105 and a lowermost one of the lower channel layers 110C, between the lower channel layers 110C, and between the uppermost one of the lower channel layers 110C and the isolation layer 130, according to an embodiment. Since each of the lower channel layers 110C and the isolation layer 130 is surrounded by the gate dielectric layer 115D, the lower work-function metal layer 115F may be interposed between portions of the gate dielectric layer 115D that are formed on the top surface of the substrate 105, top and bottom surfaces of the lower channel layers 110C, and a bottom surface of the isolation layer 130, according to an embodiment.

In contrast, the upper work-function metal layer 125F may be formed on the gate dielectric layer 115D that surrounds each of the upper channel layers 120C. Further, the upper work-function metal layer 125F may also be formed on side surfaces of the lower channel layers 110C and the isolation layer 130, and a top surface of the isolation layer 130 as shown in FIG. 1C, according to an embodiment. Further, the upper work-function metal layer 125F may be formed on the top surface of the STI structure 106, and the sidewalls of the isolation structure 150-1, 150-2 and the ILD structure 160 with the gate dielectric layer 115D therebetween, according to an embodiment.

The lower work-function metal layer 115F and the upper work-function metal layer 125F may each be formed of titanium (Ti), tantalum (Ta) or their compound such as TiN, TiAl, TiAlN, TaN, TiC, TaC, TiAlC, TaCN, TaSiN, not being limited thereto. However, when the two nanosheet transistors 10L and 10U are to form an NFET and a PFET, respectively, the lower work-function metal layer 115F and the upper work-function metal layer 125F may be formed of different materials or material compounds. For example, to form the NFET, a combination of TiN and TiC may be included in the upper work-function metal layer 125F, while TiN without TiC or without carbon may be included in the lower work-function metal layer 115F to form the PFET. However, the embodiments are not limited thereto. The lower work-function metal layer 115F may be for the NFET, while the upper work-function metal layer 125F may be for the PFET, or both of the work-function metal layers 115F and 125F may be one of the NFET and the PFET.

Alternatively, or additionally, the lower work-function metal layer 115F and the upper work-function metal layer 125F may have different thicknesses in defining the same or different gate threshold voltages or controlling an amount of current flow for the lower nanosheet transistor 10L and the upper nanosheet transistor 10U, respectively, according to embodiments.

The gate structure 115 of the multi-stack semiconductor device 10 may further include the gate electrode pattern 115E as a gate electrode shared by the lower nanosheet transistor 10L and the upper nanosheet transistor 10U. The gate electrode pattern 115E may be formed on the upper work-function metal layer 125F.

According to an embodiment, the gate electrode pattern 115E may be formed between the upper channel layers 120C, while the gate electrode pattern 115E may not be formed between the lower channel layers 110C, as shown in FIGS. 1A-1C, according to an embodiment. This is because, as described earlier, the upper channel layers 120C has a greater channel interval than the lower channel layers 110C.

Since each of the upper channel layers 120C is surrounded by the gate dielectric layer 115D with the upper work-function metal layer 125F thereon, the gate electrode pattern 115E may be provided between the upper work-function metal layer 125F formed on the gate dielectric layer 115D on a bottom surface of each upper channel layer 120C and the upper work-function metal layer 125F formed on the gate dielectric layer 115D on a top surface of an upper channel layer 120C immediately below the each upper channel layer, according to an embodiment. Thus, when the upper channel interval INT2 of the upper channel layer 120C is about 7-9 nm as exampled above, a thickness TH2 of the gate structure 115, including the gate electrode pattern 115E, between the vertically neighboring upper channel layers may also be about 7-9 nm.

Further, the gate electrode pattern 115E may also be formed between the upper work-function metal layer 125F formed on the gate dielectric layer 115D on a bottom surface of the lowermost upper channel layer 120C and the upper work-function metal layer 125F formed on the gate dielectric layer 115D on a top surface of the isolation layer 130. According to an embodiment, a thickness of the gate structure 115, including the gate electrode pattern 115E, between the lowermost upper channel layer 120C and the isolation layer 130 may also be about 7-9 nm.

In contrast, between the lower channel layers 110C, the gate dielectric layer 115D on a bottom surface of each lower channel layer, the lower work-function metal layer 115F on this gate dielectric layer 115D, and the gate dielectric layer 115D on a top surface of a lower channel layer immediately below each lower channel may be provided without the gate electrode pattern 115E. Thus, when the lower channel interval INT1 of the lower channel layer 110C is about 4-6 nm as exampled above, a thickness TH1 of the gate structure 115, without the gate electrode pattern 115E, between the lower channel layers 110C may also be about 4-6 nm.

Further, between the isolation layer 130 and the uppermost one of the lower channel layers 110C, the gate dielectric layer 115D on the bottom surface of the isolation layer 130, the lower work-function metal layer 115F thereon, and the gate dielectric layer 115D on a top surface of the uppermost one of the lower channel layers 110C may be provided without the gate electrode pattern 115E. According to an embodiment, a thickness of the gate structure 115, without the gate electrode pattern 115E, between the isolation layer 130 and the uppermost lower channel layer may also be about 4-6 nm. In addition, between the lowermost lower channel layer and the substrate 105, the gate dielectric layer 115D on a bottom surface of the lowermost channel layer, the lower work-function metal layer 115F thereon, and the gate dielectric layer 115D on the substrate 105 may be provided without the gate electrode pattern 115E. According to an embodiment, a thickness of the gate structure 115, without the gate electrode pattern 115E, between the lowermost lower channel layer and the substrate 105 may also be about 4-6 nm.

According to an embodiment, the gate electrode pattern 115E may be a common electrode of the lower nanosheet transistor 10L and the upper nanosheet transistor 10U. The gate electrode pattern 115E may include tungsten (W), ruthenium (Ru), molybdenum (Mo), cobalt (Co), aluminum (Al), copper (Cu), polycrystalline silicon, doped-polycrystalline silicon or their compound, not being limited thereto, to receive an input voltage for the multi-stack semiconductor device 10 or for an internal routing of the multi-stack semiconductor device 10 to an adjacent circuit in an integrated circuit including the multi-stack semiconductor device 10. For example, the multi-stack semiconductor device 10 may be a CMOS inverter in which two transistors share a same gate input signal through a common gate electrode.

In the meantime, when the upper work-function metal layer 125F surrounds or is formed on side surfaces of at least the lower channel layers 110C with the gate dielectric layer 115D therebetween as shown in FIG. 1C, the upper work-function metal layer 125F tailored to form an NFET or PFET for the upper nanosheet transistor 10U may affect the opposite-polarity lower nanosheet transistor 10L. However, the lower work-function metal layer 115F is formed on top and bottom surfaces of the lower channel layers 110C along the entire width thereof, the influence of the upper work-function metal layer 125F formed at the side surfaces of the lower channel layers 110C may be negligible or minimized.

Thus, the multi-stack semiconductor device 10 shown in FIGS. 1A-1E may be able to provide the lower work-function metal layer 115F which may not have been subject to possible etching or damaging during the formation of the upper work-function metal layer 125F in a process of manufacturing the multi-stack semiconductor device 10.

Here below, a method of manufacturing the multi-stack semiconductor device 10 shown in FIGS. 1A-1E is described.

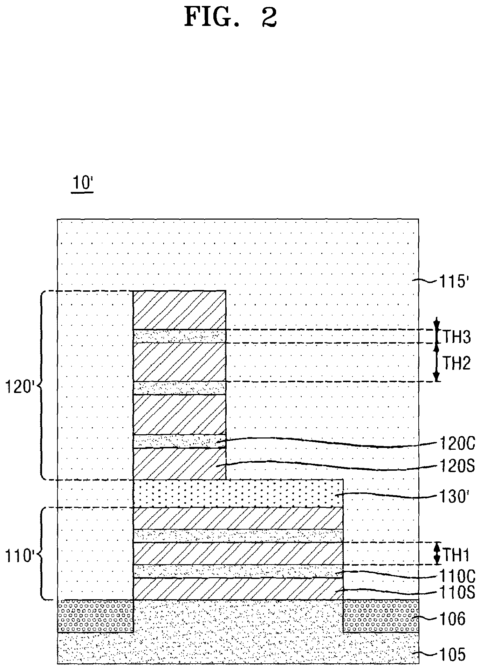

FIGS. 2-7 illustrate multi-stack structures after respective steps of a method of manufacturing the multi-stack semiconductor device 10 shown in FIGS. 1A-1E, according to an embodiment. Here below, the method of manufacturing the multi-stack semiconductor device 10 is described in reference to FIGS. 2-7 which show only the channel-width direction of the intermediate multi-stack structures for brevity purposes.

The multi-stack structures shown in FIGS. 2-7 correspond to the multi-stack semiconductor device 10 shown in FIGS. 1A-1D. Various structures and elements forming the multi-stack semiconductor device 10 may be the same or similar to those of the multi-stack structures shown in FIGS. 2-7 in terms of their structural, functional and material characteristics. Thus, duplicate descriptions the same or corresponding structures or elements may be omitted here below. The same reference numbers and reference characters used for describing the multi-stack semiconductor device 10 in FIGS. 1A-1D may be used here below when the same structures or elements are referred to.

Referring to FIG. 2, a multi-stack structure 10' enclosed by a dummy gate structure 115' is provided on the substrate 105, according to an embodiment. The STI structure 106 may also be formed on or around the substrate 105. The multi-stack structure 10' may include a lower nanosheet stack 110', an isolation sacrificial stack 130' and an upper nanosheet stack 120' in this order on the substrate 105, and each of the lower nanosheet stack 110' and the upper nanosheet stack 120' may be formed of a plurality of semiconductor nanosheet layer (hereafter "nanosheet layers") that includes at least one sacrificial layer and at least one channel layer as described below.

In the multi-stack structure 10', the upper nanosheet stack 120' may have a shorter width than the lower nanosheet stack 110' so that the upper source/drain regions 122 to be grown from the upper channel structure 120, to be formed from the upper nanosheet stack 120', may have a shorter width than the lower source/drain regions 112 to be grown on the lower channel structure 110 to be formed from the lower nanosheet stack 110'. By having the shorter-width upper source/drain regions 122, a contact structure to connect at least one of the lower source/drain regions 112 to an FEOL structure may be extended down straight from the FEOL structure through a space above the lower source/drain regions 112 is not vertically overlapped by one of the upper source/drain regions 122 above the lower source/drain regions 112.

The lower nanosheet stack 110' may include the lower sacrificial layers 110S and the lower channel layers 110C alternatingly stacked on the substrate 105. Further, the upper nanosheet stack 120' may include the upper sacrificial layers 120S and the upper channel layers 120C also alternatingly stacked on the lower nanosheet stack 110'. Although not shown, the isolation sacrificial structure 130' may also include a plurality of nanosheet layers.

In the embodiments presented herein, the dummy gate structure 115' is referred to as such because this structure is not used as a gate structure of the multi-stack semiconductor device 10 to be formed, and instead, may be replaced by a replacement gate structure after supporting formation of other structures of the multi-stack semiconductor device 10 in a later step of the manufacturing method. Similarly, the sacrificial layers 110S and 120S and the isolation sacrificial structure 130' are referred to as such because these layers and structure are also to be removed after supporting formation of other structures in a later step of the manufacturing method.

According to an embodiment, the nanosheet stacks 110' and 120' may be formed by epitaxially growing nanosheet layers one layer and then next in the following order: a lower sacrificial layer, a lower channel layer, a lower sacrificial layer, a lower channel layer, a lower sacrificial layer, one or more layers for an isolation sacrificial structure, an upper sacrificial layer, an upper channel layer, an upper sacrificial layer, an upper channel layer, an upper sacrificial layer, an upper channel layer, and an upper sacrificial layer. However, the above example number of these layers does not limit the disclosure. Further, the epitaxial growth process may be performed by, for example, applying a silicon-containing gas and/or a germanium-containing gas to grow and deposit each nanosheet layer on the substrate 105 by adjusting the gas exposure time so that a desired thickness for the nanosheet layer can be achieved. This epitaxy process may last until a desired number of channel layers and sacrificial layers is formed.

As will be described later, the lower channel layers 110C are provided to form lower channels for current flow between the lower source/drain regions 112 of the lower nanosheet transistor 10L, and the upper channel layers 120C are provided to form upper channels for current flow between the upper source/drain regions 122 of the upper nanosheet transistor 10U, in the multi-stack semiconductor device 10 to be formed from the multi-stack structure 10'.

The channel layers 110C and 120C each may be epitaxially grown to have a thickness TH3 of about 4-6 nm, not being limited thereto, according to an embodiment. The lower sacrificial layers 110S each may be epitaxially grown to have a thickness TH1 of about 4-6 nm, not being limited thereto, and the upper sacrificial layers 120S each may be epitaxially grown to have a thickness TH2 of about 7-9 nm, not being limited thereto, according to an embodiment. The isolation sacrificial structure 130' may have a thickness similar to one of the channel layers 110C and 120C. As will be described in a later step, the thickness TH1 of the lower sacrificial layer 110S may be equal to the thickness TH1 of the gate structure 115, which does not include the gate electrode pattern 115E, between the lower channel layers 110C, and the thickness TH2 of the upper sacrificial layer 120S may be equal to the thickness TH2 of the gate structure 115, which includes the gate electrode pattern 115E, between the upper channel layers 120C.

The nanosheet stacks 110' and 120' including the channel layers 110C and 120C, respectively, may be enclosed by the dummy gate structure 115'. This dummy gate structure 115', the sacrificial layers 110S and 120S, and the isolation sacrificial structure 130' may be used at least to support the formation of the source/drain regions 112 and 122, the inner spacers 117 and 127, the 1^{st} isolation structure 150-1, the 2^{nd} isolation structure 150-2, and the ILD structure 160 shown in FIGS. 1A-1D. Thus, although not shown, the multi-stack structure 10' shown in the channel-width direction view of FIG. 2 may include the source/drain regions 112 and 122, the inner spacers 117 and 127, the isolation structure 150-1, the isolation structures 150-1 and 150-2, and the ILD structure 160 formed therein based on the dummy gate structure 115' and the sacrificial layers 110S and 120S, and the isolation sacrificial structure 130' before a next step of the manufacturing method is performed. Here, the 1^{st} isolation structure 150-1 may be a diffusion break structure, and the 2^{nd} isolation structure 150-2 may be a gate-cut structure, according to an embodiment.

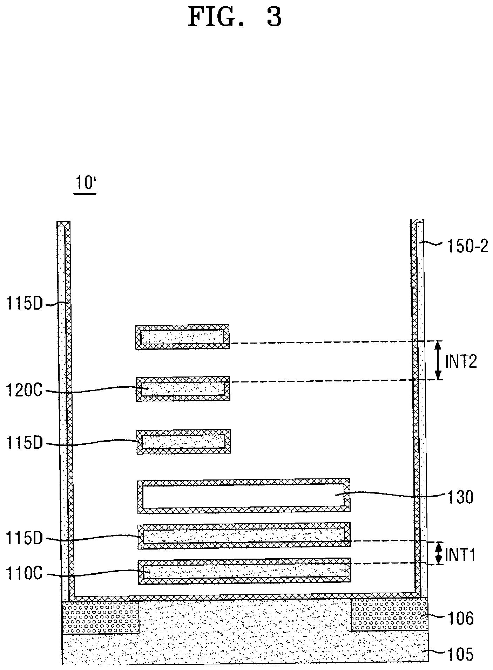

Referring to FIG. 3, the dummy gate structure 115', the sacrificial layers 110S and 120S, and the isolation sacrificial structure 130' may be removed, and the removed isolation sacrificial structure 130' may be replaced by the isolation layer 130 in the multi-stack structure 10', according to an embodiment.

These structures of the multi-stack structure 10' may be removed after the formation of the source/drain regions 112 and 122, the inner spacers 117 and 127, the isolation structures 150-1 and 150-2, and the ILD structure 160 in the previous step. Thus, the channel layers 110C and 120C may be released from the removed structures.

The channel release operation in this step may be performed through, for example, applying isotropic and/or anisotropic reactive ion etching (RIE), wet etching and/or a chemical oxide removal (COR) process, not being limited thereto, on the multi-stack structure 10' provided in the previous step. The isolation layer 130 may be formed to replace the isolation sacrificial structure 130' through, for example, physical vapor deposition (PVD), chemical vapor deposition (CVD), plasma enhanced chemical vapor deposition (PECVD), atomic layer deposition (ALD) or a combination thereof, not being limited thereto.

After this channel release operation, the lower nanosheet stack 110' and the upper nanosheet stack 120' becomes the lower channel structure 110 and the upper channel structure 120, respectively, in which the lower channel interval INT1 and the upper channel interval INT2 may be secured, according to an embodiment. The channel intervals INT1 and INT2 may be equal to the thicknesses TH1 and TH2 of the removed sacrificial layers 110S and 120S, respectively. The lower channel interval INT1 (TH1), which may be about 4-6 nm, is smaller than the upper channel interval INT2 (TH2), which may be about 7-9 nm, not being limited thereto, as described earlier.

Further, after the channel release operation, the gate dielectric layer 115D may be formed on the multi-stack structure 10' where the channel layers 110C and 120C are released, and the isolation layer 130 is formed to isolate the two channel structures 110 and 120 from each other. The gate dielectric layer 115D may be formed to surround each of the channel layers 110C, 120C and the isolation layer 130. The gate dielectric layer 115D may also be formed on the substrate 105, extended on STI structure 106 out to the 2^{nd} isolation structure 150-2, and formed on the sidewalls of the 2^{nd} isolation structure 150-2, as shown in FIG. 3. Although not shown in FIG. 3, the gate dielectric layer 115D may also be formed on the sidewalls of the 1^{st} isolation structure 150-1 and the ILD structure 160 (shown in FIGS. 1A-1D). In this step, the gate dielectric layer 115D may be formed through, for example, atomic layer deposition (ALD), not being limited thereto.

Although not separately shown, before the dummy gate structure 115', the sacrificial layers 110S and 120S, and the isolation sacrificial structure 130' may be removed in this step, a fin-cut operation and a gate-cut operation may be performed on the multi-stack structure 10' obtained in the previous step, so that the 1^{st} isolation structure 150-1 and the 2^{nd} isolation structure 150-2 may be formed at sides of the multi-stack structure 10' in the channel-length direction and the channel-width direction, respectively. The 1^{st} isolation structure 150-1 may be a diffusion break structure, and the 2^{nd} isolation structure 150-2 may be a gate-cut structure.

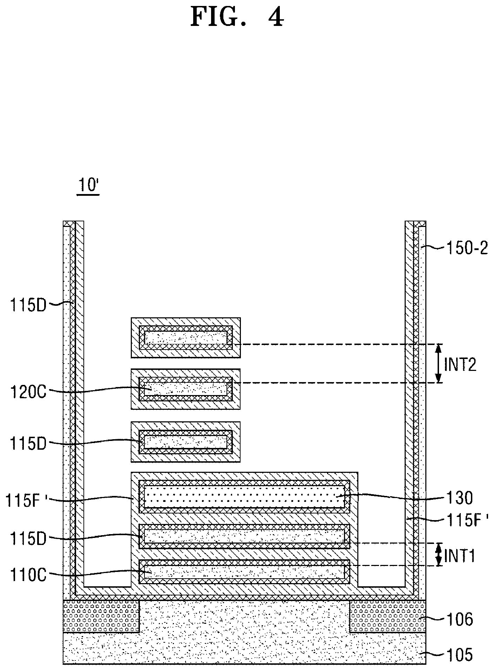

Referring to FIG. 4, an initial work-function metal layer 115F' may be formed on the gate dielectric layer 115D formed on the multi-stack structure 10' in the previous step, according to an embodiment.

Thus, the initial work-function metal layer 115F' may be formed to surround the lower channel layers 110C, the upper channel layers 120C and the isolation layer 130, and formed on the STI structure 106, the sidewalls of the isolation structures 150-1, 150-2 and the ILD structure 160, with the gate dielectric layer 115D thereunder. The formation of the initial work-function metal layer 115F' may also be performed through atomic layer deposition (ALD), not being limited thereto.

As described earlier, due to the lower channel interval INT1 being smaller than the upper channel interval INT2, the initial work-function metal layer 115F' along with the gate dielectric layer 115D may fill out a space between the lower channel layers 110C. Further, the initial work-function metal layer 115F' and the gate dielectric layer 115D may also fill out a space between the substrate 105 and the lowermost one of the lower channel layers 110C and a space between the uppermost one of the lower channel layers 110C and the isolation layer 130. However, after the formation of the initial work-function metal layer 115F', spaces between the upper channel layers 120C and between the isolation layer 130 and the lowermost one of the upper channel layers 120C remain void.

The initial work-function metal layer 115F' formed in this step is to form the lower work-function metal layer 115F, and thus, the initial work-function metal layer 115F' may include the same material or material compound included in the lower work-function metal layer 115F. A combination of TiN and TiC may be used as the material of the initial work-function metal layer 115F' to form an NFET, and TiN without TiC or carbon may be used to form a PFET.

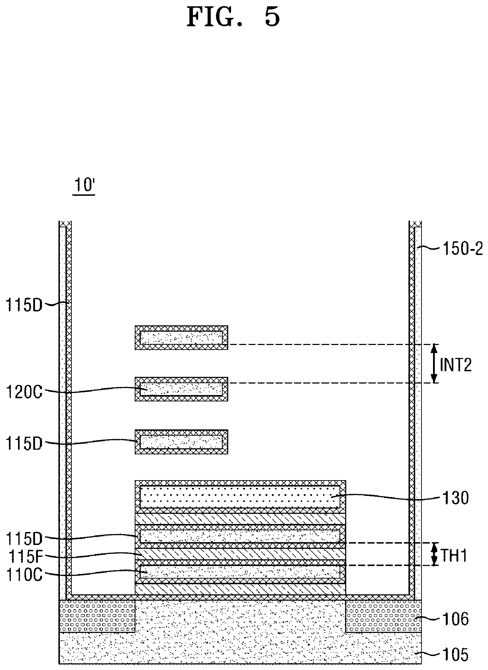

Referring to FIG. 5, the initial work-function metal layer 115F' may be removed from the multi-stack structure 10' obtained in the previous step, except portions thereof formed between the lower channel layers 110C, between the substrate 105 and the lowermost one of the lower channel layers 110C, and between the uppermost one of the lower channel layers 110C and the isolation layer 130, according to an embodiment.

Thus, the initial work-function metal layer 115F' may be removed from the upper channel layers 120C, the top surface and side surfaces of the isolation layer 130, side surfaces of the lower stack including the lower channel layers 110C, the top surface of the STI structure 106 and the sidewalls of the isolation structure 150-1, 150-2 and the ILD structure 160, leaving the gate dielectric layer 115D thereunder.

In this step, the initial work-function metal layer 115F' may be removed through, for example, wet etching using a wet etchant including, for example, hydrogen peroxide, not being limited thereto that may selectively attack the materials, such as TiN and/or TiC, forming the initial work-function metal layer 115F' against the materials forming the gate dielectric layer 115D. Thus, the gate dielectric layer 115D may not be affected by the wet etching removing the initial work-function metal layer 115F' except portions thereof at the above-described selected spaces. These etchants may undergo a "pinch off' effect in the narrow gap defined by the thickness TH1, but not in gaps defined by the thickness TH2, so that the initial work-function metal layer 115F' is not etched in the spaces having the thickness TH1.

After the removal operation in this step, the initial work-function metal layer 115F' remaining between the lower channel layers 110C, between the substrate 105 and the lowermost one of the lower channel layers 110C, and between the uppermost one of the lower channel layers 110C and the isolation layer 130 becomes the lower work-function metal layer 115F of the multi-stack semiconductor device 10. Further, this lower work-function metal layer 115F with the gate dielectric layer 115D on top and bottom surfaces thereof between two neighboring lower channel layers 110C has the thickness TH1.

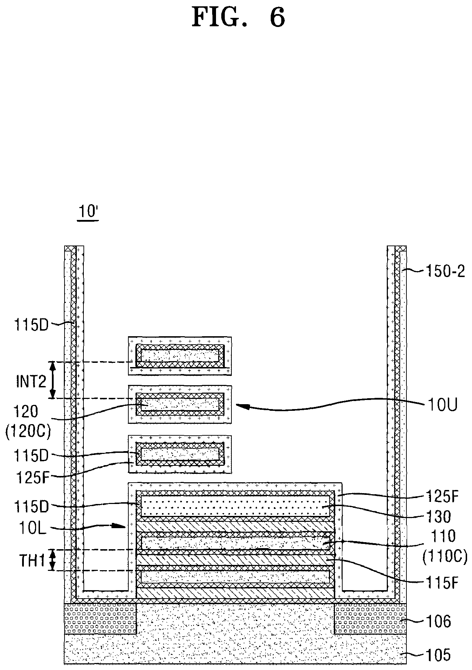

Referring to FIG. 6, the upper work-function metal layer 125F may be formed on the multi-stack structure 10' obtained in the previous step, according to an embodiment.

In this step, the upper work-function metal layer 125F may replace the initial work-function metal layer 115F' removed from the previous step. Thus, the upper work-function metal layer 125F may be formed to surround the gate dielectric layer 115D on the upper channel layers 120C, the gate dielectric layer 115D on the top and side surfaces of the isolation layer 130, and the gate dielectric layer 115D on the side surfaces of the lower channel layers 110C, according to an embodiment. The upper work-function metal layer 125F may also be formed on side surfaces of the lower work-function metal layer 115F.

Although the upper work-function metal layer 125F defining the polarity or gate threshold voltage is formed at the side surfaces of the lower channel layers 110C, the influence of the upper work-function metal layer 125F on the lower channel layers 110C may be negligible or minimized. This is because, as described in reference to FIGS. 1A-1D, the lower work-function metal layer 115F is formed on the top and bottom surfaces of the lower channel layers 110C along the entire width thereof.

The formation of the upper work-function metal layer 125F may also be performed through the ALD technique.

Alternatively, and/or additionally, the upper work-function metal layer 125F replacing the initial work-function metal layer 115F' may be formed to be sufficiently thicker so that the spaces between the upper channel layers 120C and/or the space between the lowermost one of the upper channel layers 120C and the isolation layer 130 may be filled out by the upper work-function metal layer 125F, according to an embodiment.

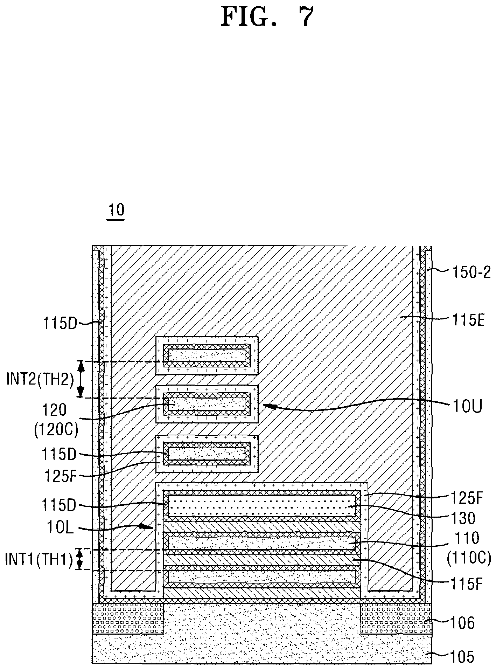

Referring to FIG. 7, the gate electrode pattern 115E may be formed on the multi-stack structure 10' obtained in the previous step, and planarized to finish the gate structure 115 of the multi-stack semiconductor device 10, according to an embodiment.

Thus, the gate electrode pattern 115E may be formed to surround the upper work-function metal layer 125F. The formation of the gate electrode pattern 115E in this step may be formed through, for example, physical vapor deposition (PVD), chemical vapor deposition (CVD), plasma enhanced chemical vapor deposition (PECVD), or combinations thereof, not being limited thereto. The planarization of the gate electrode pattern 115E may be performed through, for example, a chemical mechanical planarization (CMP) technique, not being limited thereto, so that a top surface of the gate electrode pattern 115E may be coplanar with the upper work-function metal layer 125F formed on the sidewalls of the isolation structures 150-1, 150-2 and the ILD structure 160.

The gate electrode pattern 115E formed in this step may be shared by the lower work-function metal layer 115F of the lower nanosheet transistor 10L and the upper work-function metal layer 125F of the upper nanosheet transistor 10U in the multi-stack semiconductor device 10 to receive a same gate input signal.

Although not shown, when the gate electrode pattern 115E is divided by a lower gate electrode pattern and an upper gate electrode pattern isolated from each other, the lower nanosheet transistor 10L and the upper nanosheet transistor 10U may not share the same gate input signal, according to an embodiment.

Through the above method, the multi-stack semiconductor device 10 may be manufactured without complicated patterning and/or deposition steps that may be required for protecting an early-formed lower work-function metal layer to form an upper work-function metal layer.

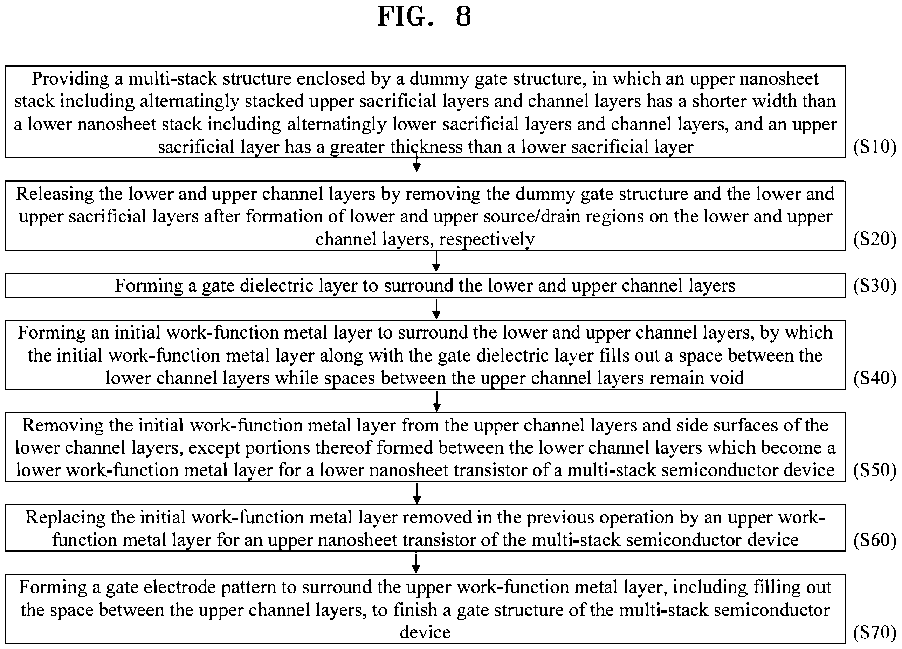

FIG. 8 illustrates a flowchart for a method of manufacturing a multi-stack semiconductor device in which a lower nanosheet transistor and an upper nanosheet transistor have a different channel layer interval, according to an embodiment.

In operation S10, a multi-stack structure enclosed by a dummy gate structure is provided on a substrate 105, in which an upper nanosheet stack including a plurality of alternatingly stacked upper sacrificial layers and channel layers has a shorter width than a lower nanosheet stack including a plurality of alternatingly stacked lower sacrificial layers and channel layers, and a upper sacrificial layer has a greater thickness than a lower sacrificial layer (as shown FIG. 2).

There may be an isolation sacrificial structure formed between the lower nanosheet stack and the upper nanosheet stack.

In operation S20, the lower channel layers and the upper channel layers are released by removing the dummy gate structure and the lower sacrificial layers and the upper sacrificial layers after formation of lower source/drain regions and upper source/drain regions on the lower channel layers and the upper channel layers, respectively, based on the dummy gate structure, the lower sacrificial layers and the upper sacrificial layers (as shown in FIG. 3).

After the channel release operation, the upper channel layers may have a greater channel interval since the upper sacrificial layer had a greater thickness than the lower sacrificial layer. In this channel release operation, the isolation sacrificial structure may also be removed, and replaced by an isolation layer.

In operation S30, a gate dielectric layer is formed to surround the lower channel layers and the upper channel layers (as shown in FIG. 3).

In this operation, the gate dielectric layer may also be formed to surround the isolation layer.

In operation S40, an initial work-function metal layer is formed to surround the lower channel layers and the upper channel layers, by which the initial work-function metal layer along with the gate dielectric layer fills out a space between the lower channel layers while a space between the upper channel layers remains void because of the channel interval difference.

The initial work-function metal layer may also fill out a space between the substrate and the lowermost channel layer and between the uppermost channel layer and the isolation layer.

In operation S50, the initial work-function metal layer is removed from the upper channel layers and side surfaces of the lower channel layers, except portions thereof formed between the lower channel layers which become a lower work-function metal layer for a lower nanosheet transistor of a multi-stack semiconductor device (as shown in FIG. 5).

The initial work-function metal layer may also be removed from top and side surfaces of the isolation layer.

The initial work-function metal layer remaining in the multi-stack structure after this operation becomes a lower work-function metal layer of the multi-stack semiconductor device to be formed from the multi-stack structure.

In operation S60, an upper work-function metal layer for an upper nanosheet transistor of the multi-stack semiconductor device replaces the initial work-function metal layer removed in the previous operation (as shown in FIG. 6).

Thus, the upper work-function metal layer may be formed to surround the gate dielectric layer on the upper channel layers, and may also be formed on the side surfaces of the lower channel layers. Further, the upper work-function metal layer may also be formed on the top and side surfaces of the isolation layer.

In operation S70, a gate electrode pattern is formed to surround the upper work-function metal layer finish a gate structure of the multi-stack semiconductor device (as shown in FIG. 7).

As the gate electrode pattern is formed to surround the upper work-function metal layer, the space between the upper channel layers may be filled out by the gate electrode pattern, although the gate electrode pattern may not be formed in the space between the lower channel layers which is filled out by the lower work-function metal layer because of the channel interval difference as described above.

The gate electrode pattern formed in this operation may be shared by the lower work-function metal layer for the lower nanosheet transistor and the upper work-function metal layer for the upper nanosheet transistor in the multi-stack semiconductor device.

Thus far, the embodiments have been directed to a multi-stack semiconductor device formed of a lower nanosheet transistor and an upper nanosheet transistor having different channel widths, the disclosure may also apply to a multi-stack semiconductor device in which a channel structure of a lower nanosheet transistor and a channel structure for a upper nanosheet transistor have an equal channel width, according to embodiments.

Further, the present disclosure may apply to a hybrid multi-stack semiconductor device including a nanosheet transistor and a fin field-effect transistor (FinFET) as a lower field effect transistor and an upper field-effect transistor, respectively, according to embodiments. The FinFET may have one or more vertical fin structures as a channel layer of the transistor. In this case, the lower nanosheet transistor may have the same structure as the lower nanosheet transistor 10L of the multi-stack semiconductor device 10 described above.

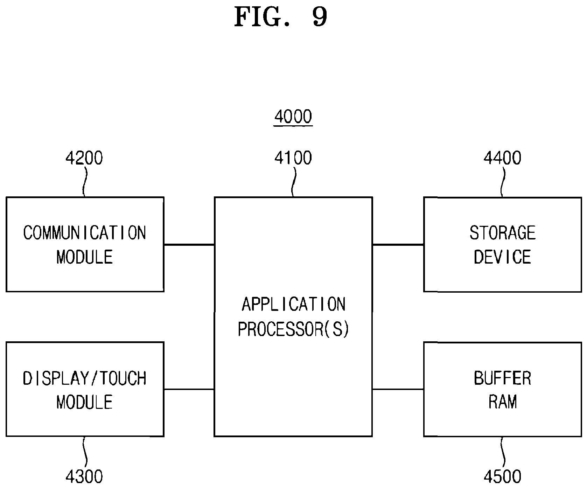

FIG. 9 is a schematic block diagram illustrating an electronic device including a multi-stack semiconductor device in which a channel layer interval is different at a lower nanosheet transistor and an upper nanosheet transistor, according to an embodiment.

Referring to FIG. 9, an electronic device 4000 may include at least one application processor 4100, a communication module 4200, a display/touch module 4300, a storage device 4400, and a buffer RAM 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid-state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random-access memory (SDRAM), low power double data rate (LPDDR) SDRAM, graphics double data rate (GDDR) SDRAM, Rambus dynamic random-access memory (RDRAM), etc.

At least one component in the electronic device 4000 may include the multi-stack semiconductor devices described above in reference to FIGS. 1A-1E to FIG. 8.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

## Claims

1. A multi-stack semiconductor device (10) comprising:
a lower nanosheet transistor (10L) comprising a plurality of lower channel layers (110C) surrounded by a gate structure (115); and
an upper nanosheet transistor (10U) stacked on the lower nanosheet transistor (10L) and comprising a plurality of upper channel layers (120C) surrounded by the gate structure (115),
wherein the lower channel layers (110C) have a smaller channel interval (INT1, INT2) than the upper channel layers (120C).

2. The multi-stack semiconductor device (10) of claim 1, wherein the gate structure (115) comprises:
a lower work-function metal layer (115F) formed on the lower channel layers (110C); and
a gate electrode pattern (115E) configured to receive a gate input signal,
wherein the lower work-function metal layer (115F) is formed between the lower channel layers (110C), and the gate electrode pattern (115E) is not formed between the lower channel layers (110C).

3. The multi-stack semiconductor device (10) of claim 2, wherein the gate structure (115) further comprises an upper work-function metal layer (125F) formed on the upper channel layers (120C), and
wherein the upper work-function metal layer (125F) and the lower work-function metal layer (115F) have different thicknesses, respectively.

4. The multi-stack semiconductor device (10) of claim 2, wherein the gate structure (115) further comprises an upper work-function metal layer (125F) formed on the upper channel layers (120C),
wherein the upper work-function metal layer (125F) and the lower work-function metal layer (115F) are formed of different materials, respectively, and
wherein the upper work-function metal layer (125F) is further formed on side surfaces of the lower channel layers (110C), preferably wherein the upper work-function metal layer (125F) is further formed on side surfaces of the lower work-function metal layer (115F) formed between the lower channel layers (110C), preferably wherein the gate electrode pattern (115E) is formed between the upper channel layers (120C).

5. The multi-stack semiconductor device (10) of any one of the previous claims, wherein the upper channel layers (120C) have a smaller width than the lower channel layers (110C), preferably wherein a number of the upper channel layers (120C) is greater than a number of the lower channel layers (110C).

6. The multi-stack semiconductor device (10) of any one of the previous claims, wherein each of the lower channel layers (110C) and the upper channel layers (120C) has an equal thickness (TH3).

7. A multi-stack semiconductor device (10) comprising:
a lower nanosheet transistor (10L) comprising a plurality of lower channel layers (110C) surrounded by a gate structure (115); and
an upper nanosheet transistor (10U) stacked on the lower nanosheet transistor (10L) and comprising a plurality of upper channel layers (120C) surrounded by the gate structure (115),
wherein the gate structure (115) comprises a lower work-function metal layer (115F) formed on the lower channel layers (110C), an upper work-function metal layer (125F) formed on the upper channel layers (120C), and a gate electrode pattern (115E) formed on the upper work-function metal layer (125F), and
wherein the gate electrode pattern (115E) is formed between the upper channel layers (120C), and is not formed between the lower channel layers (110C).

8. The multi-stack semiconductor device (10) of claim 7, wherein the upper work-function metal layer (125F) and the lower work-function metal layer (115F) are formed of different materials, respectively, and/or
wherein the upper work-function metal layer (125F) and the lower work-function metal layer (115F) have different thicknesses, respectively, and/or
wherein the upper work-function metal layer (125F) is formed on side surfaces of the lower channel layers (110C), and side surfaces of the lower work-function metal layer (115F) formed between the lower channel layers (110C), and/or
wherein each of the lower channel layers (110C) and the upper channel layers (120C) has an equal thickness, and/or
wherein the lower channel layers (110C) have a smaller channel interval (INT1, INT2) than the upper channel layers (120C), and/or
wherein the upper channel layers (120C) have a smaller width than the lower channel layers (110C), and wherein a number of the upper channel layers (120C) is greater than a number of the lower channel layers (110C).

9. A multi-stack semiconductor device (10) comprising:
a lower nanosheet transistor (10L) comprising a plurality lower channel layers (110C) surrounded by a gate structure (115); and
an upper nanosheet transistor (10U) stacked on the lower nanosheet transistor (10L) and comprising a plurality of upper channel layers (120C) surrounded by the gate structure (115),
wherein the gate structure (115) comprises a lower work-function metal layer (115F) formed on the lower channel layers (110C), and an upper work-function metal layer (125F) formed on the upper channel layers (120C),
wherein the upper work-function metal layer (125F) and the lower work-function metal layer (115F) are formed of different materials, respectively, and
wherein the upper work-function metal layer (125F) is formed on side surfaces of lower channel layers (110C) and side surfaces of the lower work-function metal layer (115F) formed between the lower channel layers (110C).

10. The multi-stack semiconductor device (10) of claim 9, wherein the upper channel layers (120C) have a smaller width than the lower channel layers (110C), and/or wherein a number of the upper channel layers (120C) is greater than a number of the lower channel layers (110C).

11. A multi-stack semiconductor device (10) comprising:
a lower field-effect transistor (10L) comprising one or more lower channel layers (110C) surrounded by a gate structure (115); and
an upper field-effect transistor (10U) stacked on the lower field-effect transistor (10L) and comprising one or more upper channel layers (120C) surrounded by the gate structure (115),
wherein the gate structure (115) comprises a lower work-function metal layer (115F) formed on the lower channel layers (110C), an upper work-function metal layer (125F) formed on the upper channel layers (120C), and a gate electrode pattern (115E) formed on the upper work-function metal layer (125F), and
wherein the gate electrode pattern (115E) is formed between the upper channel layers (120C) and is not formed between the lower channel layers (110C).

12. The multi-stack semiconductor device (10) of claim 11, wherein the lower channel layers (110C) comprise a plurality of nanosheet channel layers vertically stacked and horizontally extended to be parallel to each other, preferably wherein the upper work-function metal layer (125F) is further formed on side surfaces of the lower channel layers (110C) and side surfaces of the lower work-function metal layer (115F) formed between the lower channel layers (110C).

13. A method of manufacturing a multi-stack semiconductor device (10), the method comprising:
providing a multi-stack structure (10') comprising a plurality of lower channel layers (110C) and a plurality of upper channel layers (120C) stacked on the lower channel layers (110C), the upper channel layers (120C) having a smaller channel width than the lower channel layers;
forming an initial work-function metal layer (115F') to surround the lower channel layers (110C) and the upper channel layers (120C);
removing the initial work-function metal layer (115F') except portions thereof between the lower channel layers (110C) so that the portions thereof form a lower work-function metal layer (115F);
replacing the removed initial work-function metal layer (115F') with an upper work-function metal layer (125F) having a material not included in the initial work-function metal layer (115F'); and
forming a gate electrode pattern (115E) on the upper work-function metal layer (125F).

14. The method of claim 13, wherein the gate electrode pattern (115E) is formed on the upper work-function metal layer (125F) such that the gate electrode pattern (115E) is formed between the upper channel layers (120C), and the gate electrode pattern (115E) is not formed between the lower channel layers (110C), preferably wherein the removed initial work-function metal layer (115F') is replaced by the upper work-function metal layer (125F) such that the upper work-function metal layer (125F) is formed on side surfaces of the lower channel layers (110C).

15. The method of claim 13, wherein the upper channel layers (120C) have a smaller width than the lower channel layers (110C).
